# EUROPEAN PATENT APPLICATION

(11) **EP 3 744 873 A1**
(43) Date of publication of application: **02.12.2020**
(21) Application number: 20172883.9
(22) Date of filing: 05.05.2020
(51) Int. Cl.: C23C 14/56, C23C 14/35, C23C 14/20, C23C 14/02, C23C 14/58, B32B 15/08, H05K 3/00, C25D 3/00, C23C 18/54, B65H 18/00, B65H 23/00, C23C 14/54, B65H 39/16

(54) **VACUUM DEPOSITION APPARATUS AND VACUUM DEPOSITION METHOD**

(30) Priority: 30.05.2019 JP 2019101221
(71) Applicant: Sumitomo Metal Mining Co., Ltd., Tokyo 105-8716 (JP)
(72) Inventor: OKAMI, Hideharu, Oji-cho Niihama-shi,, Ehime 792-0008 (JP)
(74) Representative: TBK

(57) **Abstract**

A vacuum deposition apparatus includes: an unwinding chamber for unwinding a long resin film wound around an unwinding roll; a deposition chamber for depositing a metal film on a first surface side of the resin film from the unwinding chamber; a winding chamber for winding up the resin film with the metal film around a winding roll. The deposition chamber includes a rotationally driven cooling can roll that cools the resin film transferred in a roll-to-roll manner by having the resin film wrapped on the outer peripheral surface of the can roll, and thermal load applying deposition means disposed along the outer peripheral surface. The apparatus includes a protection film laying chamber provided between the unwinding and deposition chambers for laying a protection film on a second surface side of the resin film in a transferred state to interpose the protection film between the can roll and the resin film.

## Description

### BACKGROUND OF THE INVENTION

### 1. Field of the Invention

The present invention relates to a vacuum deposition apparatus and a vacuum deposition method for wrapping a long resin film transferred in a roll-to-roll manner on the outer peripheral surface of a cooling can roll and depositing a metal film on the surface of the long resin film that is not in contact with the outer peripheral surface of the cooling can roll, and relates in particular to an improvement in a vacuum deposition apparatus and a vacuum deposition method by which the surface of a long resin film or the surface of a metal film thereon in contact with the outer peripheral surface of a cooling can roll is less prone to be scratched.

### 2. Description of the Related Art

Various types of flexible wiring substrates are used in liquid crystal panels, laptop computers, digital cameras, mobile phones, and so on. As the material of such a flexible wiring substrate, a metal film-coated resin film is used which is a heat-resistant resin film with a metal film formed on one or both of its surfaces. By applying a thin film processing technique such as photolithography or etching to this metal film-coated resin film, a flexible wiring substrate including a predetermined wiring pattern can be obtained. In recent years, the wiring patterns on flexible wiring substrates have increasingly become finer and denser and it has become more important to eliminate defects such as pinholes in the metal films of metal film-coated resin films.

Conventional methods of manufacturing this type of metal film-coated resin film have known such as: a manufacturing method in which a metal foil is attached to a heat-resistant resin film with an adhesive (referred to as the three-layer substrate manufacturing method); a manufacturing method in which a metal foil is coated with a heat-resistant resin solution and then the resin solution is dried (referred to as the casting method); and a method in which a metal film is deposited on a heat-resistant resin film by a vacuum deposition method or a manufacturing method in which a metal film is deposited on a heat-resistant resin film by a vacuum deposition method and a wet plating layer is formed on the metal film by a wet plating method (referred to as the metallizing method). Also, the vacuum deposition method in the metallizing method includes vacuum vapor deposition methods, sputtering methods, ion plating methods, ion beam sputtering methods, and so on.

As the metallizing method, Patent Document 1 discloses a method in which chromium is sputtered onto a polyimide insulating layer and then copper is sputtered to form a conductive layer on the polyimide insulating layer. Also, Patent Document 2 discloses a flexible circuit board material obtained by laminating a first metal thin film formed by sputtering a target of a copper-nickel alloy and a second metal thin film formed by sputtering a target of copper onto a polyimide film in this order. Note that a sputtering web coater is usually used to perform vacuum deposition on a heat-resistant resin film (substrate) such as a polyimide film.

In recent years, resin films with one or both surfaces coated with a metal film have been manufactured by the metallizing method as high-density wiring substrates. Specifically, such a resin film with one or both surfaces coated with a metal film has been manufactured by depositing a metal film (referred to as "metal seed") as a base on one or both surfaces of a long heat-resistant resin film by a vacuum deposition method such as sputtering and forming a wet plating layer on the metal film (metal seed) by a wet plating method. Note that the metal film (metal seed) is deposited by using a vacuum deposition apparatus such as a sputtering web coater, and the wet plating layer is formed by using a wet plating apparatus. The resin film with one or both surfaces coated with a metal film is therefore manufactured through two steps using different manufacturing apparatuses. Specifically, the long resin film with the metal film (metal seed) deposited on one or both of its surfaces by the vacuum deposition apparatus is temporarily wound up in a roll form inside the vacuum deposition apparatus, and then transferred out of the vacuum deposition apparatus into the wet plating bath in the wet plating apparatus, and the wet plating layer is formed on the metal film (metal seed) on the long resin film.

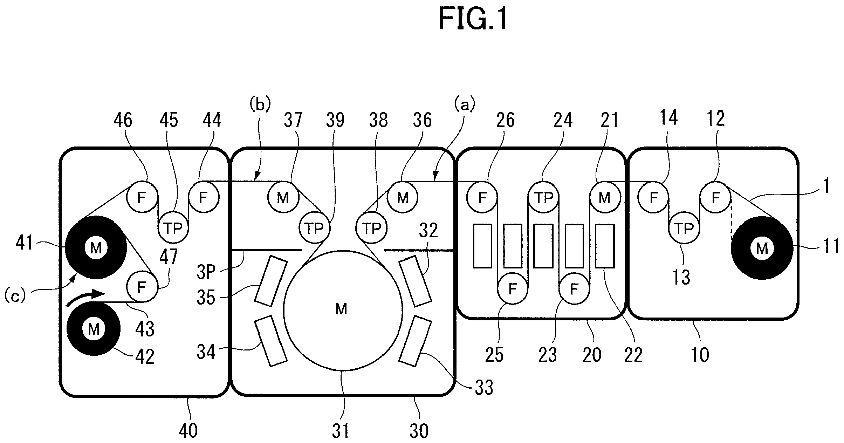

A sputtering web coater (vacuum deposition apparatus) as illustrated in FIG. 1 has heretofore been known as this type of vacuum deposition apparatus for depositing a metal film (metal seed) on one surface of a long resin film. Specifically, a sputtering web coater (vacuum deposition apparatus) has been known which, as illustrated in FIG. 1, includes: an unwinding chamber 10 in which a long resin film 1 wound around an unwinding roll 11 is unwound; a deposition chamber 30 in which a metal film (metal seed) is deposited on a first surface side of the long resin film 1 supplied from the unwinding chamber 10 and which includes a rotationally driven cooling can roll 31 that cools the long resin film 1 transferred in a roll-to-roll manner by having the long resin film 1 wrapped on the outer peripheral surface of the cooling can roll 31, and thermal load applying deposition means 32, 33, 34, and 35 that are disposed along the outer peripheral surface of the cooling can roll 31; and a winding chamber 40 in which the long resin film 1 with the metal film (metal seed) deposited thereon is wound up around a winding roll 41.

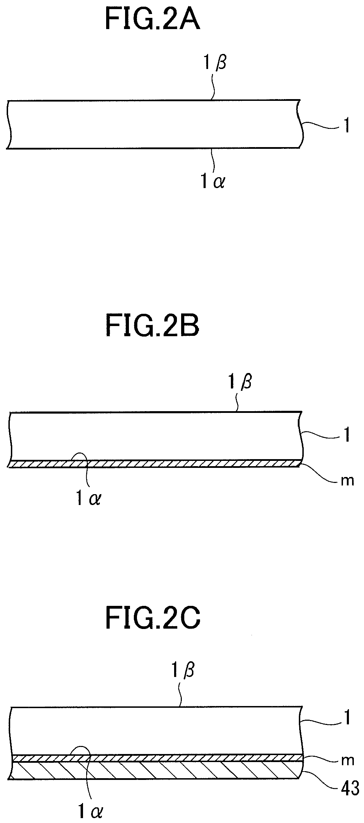

By using the sputtering web coater (vacuum deposition apparatus) illustrated in FIG. 1, a metal film m (see FIG. 2B) is deposited on a first surface 1α (see FIG. 2A) side of the long resin film 1 supplied from the unwinding chamber 10, and the long resin film 1 is collected on the winding roll 41 with an insertion sheet 43 laid on the metal film m side of the long resin film 1 (see FIG. 2C). Note that reference sign 42 in FIG. 1 denotes a long insertion sheet unwinding roll that unwinds the long insertion sheet 43 to be inserted between layers of the long resin film 1 to be collected on the winding roll 41 (an insertion sheet for preventing blocking in which the long resin film 1 gets attached to itself via the deposited metal film m). Also, the cross section of the long resin film 1 illustrated in FIG. 2A corresponds to the cross section of the long resin film 1 indicated by reference sign (a) in FIG. 1, the cross section of the long resin film 1 illustrated in FIG. 2B corresponds to the cross section of the long resin film 1 indicated by reference sign (b) in FIG. 1, and the cross section of the long resin film 1 illustrated in FIG. 2C corresponds to the cross section of the long resin film 1 indicated by reference sign (c) in FIG. 1, wound up around the winding roll 41.

Meanwhile, to deposit a metal film (metal seed) m on both surfaces of the long resin film 1 by using the sputtering web coater (vacuum deposition apparatus) illustrated in FIG. 1, the long resin film 1 after being wound up around the winding roll 41 with a metal film (metal seed) m deposited on the first surface 1α is taken out and then set on the unwinding roll 11 of the sputtering web coater (vacuum deposition apparatus) again, and the long resin film 1 with the metal film (metal seed) m deposited on the first surface 1α is transferred from the unwinding chamber 10 into the deposition chamber 30. In this way, a metal film (metal seed) m can be deposited also on a second surface 1β of the long resin film 1. In this case, the film passage route from the unwinding roll 11 is the broken line illustrated in the unwinding chamber 10.

### CONVENTIONAL ART DOCUMENTS

### PATENT DOCUMENTS

Patent Document 1: Japanese Patent Application Publication No. Hei 2-98994
Patent Document 2: Japanese Patent Application Publication No. Hei 6-97616

### SUMMARY OF THE INVENTION

Meanwhile, in the sputtering web coater (vacuum deposition apparatus) illustrated in FIG. 1, the tension of the long resin film 1 for the transfer in the deposition chamber 30 is set higher than the tension of the long resin film 1 for the transfer in other chambers such as the unwinding chamber 10 and the winding chamber 40 since the long resin film 1 is brought into tight contact with the outer peripheral surface of the cooling can roll 31. Accordingly, the long resin film 1 transferred through the deposition chamber 30 strongly contacts the outer peripheral surfaces of the cooling can roll 31 and motor driven rolls 36 and 37 provided inside the deposition chamber 30. Then, when the side of the long resin film 1 to be in contact with these outer peripheral surfaces is a film surface with no film deposited thereon, the film surface with no film deposited thereon is prone to be scratched. When the side of the long resin film 1 to be in contact with the outer peripheral surfaces is a deposited metal film, the metal film is prone to be scratched. Thus, there has been a problem in that if the film surface with no film deposited thereon is scratched, asperities will be formed on the surface of a metal film subsequently deposited on the film surface, and if the metal film is scratched, missing portions are formed in the metal film and defects such as pinholes are prone to be formed in the metal film-coated resin film.

The present invention has been made in view of such a problem and an object thereof is to provide a vacuum deposition apparatus and a vacuum deposition method by which the surface of a long resin film or the surface of a metal film thereon in contact with the outer peripheral surface of a cooling can roll is less prone to be scratched.

That is, a first aspect according to the present invention is a vacuum deposition apparatus which includes:
an unwinding chamber in which a long resin film wound around an unwinding roll is unwound;
a deposition chamber in which a metal film is deposited on a first surface side of the long resin film supplied from the unwinding chamber; and
a winding chamber in which the long resin film with the metal film deposited thereon is wound up around a winding roll,
wherein the deposition chamber includes
a rotationally driven cooling can roll that cools the long resin film transferred in a roll-to-roll manner by having the long resin film wrapped on an outer peripheral surface of the cooling can roll, and
thermal load applying deposition means disposed along the outer peripheral surface of the cooling can roll, and
the vacuum deposition apparatus includes a protection film laying chamber which is provided between the unwinding chamber and the deposition chamber and in which a protection film is laid on a second surface side of the long resin film in a state of being transferred to thereby be interposed between the cooling can roll and the long resin film.

Also, a second aspect is the vacuum deposition apparatus according to the first aspect, in which
the protection film is made of polyethylene, polypropylene, polyethylene terephthalate, polyethylene naphthalate, polystyrene, polyvinyl alcohol, polycarbonate, polyphenylene sulfide, polyether ether ketone, polyethersulfone, aramid, polyimide, or triacetate alone or of a composite material thereof laminated to each other.

A third aspect is the vacuum deposition apparatus according to the first aspect, in which
the thermal load applying deposition means includes a magnetron sputtering cathode.

Further, a fourth aspect according to the present invention is a vacuum deposition method which includes:
a film unwinding step of unwinding a long resin film wound around an unwinding roll;
a deposition step of wrapping the unwound long resin film onto a cooling can roll and depositing a metal film on a first surface side of the long resin film with a thermal load applying deposition means disposed along an outer peripheral surface of the cooling can roll;
a film winding step of winding up the long resin film with the metal film deposited thereon around a winding roll; and
between the film unwinding step and the deposition step, a step of laying a protection film on a second surface side of the long resin film to thereby interpose the protection film between the cool can roll and the long resin film.

Also, a fifth aspect is the vacuum deposition method according to the fourth aspect, in which
the protection film is made of polyethylene, polypropylene, polyethylene terephthalate, polyethylene naphthalate, polystyrene, polyvinyl alcohol, polycarbonate, polyphenylene sulfide, polyether ether ketone, polyethersulfone, aramid, polyimide, or triacetate alone or of a composite material thereof laminated to each other.

A sixth aspect is the vacuum deposition method according to the fourth aspect, in which
the thermal load applying deposition means includes a magnetron sputtering cathode.

In the vacuum deposition apparatus and the vacuum deposition method according to the present invention, the protection film is laid on the second surface side of the long resin film before the long resin film is transferred into the deposition chamber. Thus, inside the deposition chamber, the long resin film is wrapped on the outer peripheral surface of the cooling can roll with the protection film interposed therebetween.

Then, although the long resin film strongly contacts the outer peripheral surface of the cooling can roll in the deposition chamber, the protection film interposed between the long resin film and the cooling can roll makes the second surface of the long resin film less prone to be scratched. This brings about the advantage that, when the second surface side of the long resin film is a film surface with no film deposited thereon, the film surface with no film deposited thereon is less prone to be scratched, and when the second surface side is a metal film, the metal film surface is less prone to be scratched.

### BRIEF DESCRIPTION OF THE DRAWINGS

FIG. 1 is an explanatory diagram of the configuration of a sputtering web coater (vacuum deposition apparatus) according to a conventional example for depositing a metal film on one surface of a long resin film.
FIG. 2A is a cross-sectional view of a long resin film indicated by reference sign (a) in FIG. 1, FIG. 2B is a cross-sectional view of the long resin film indicated by reference sign (b) in FIG. 1, and FIG. 2C is a cross-sectional view of the long resin film indicated by reference sign (c) in FIG. 1, wound up around a winding roll.
FIG. 3 is an explanatory diagram of the configuration of a sputtering web coater (vacuum deposition apparatus) according to an embodiment of the present invention for depositing a metal film on one surface of a long resin film.
FIG. 4A is a cross-sectional view of a long resin film indicated by reference sign (A) in FIG. 3, wound around an unwinding roll, FIG. 4B is a cross-sectional view of the long resin film indicated by reference sign (B) in FIG. 3, FIG. 4C is a cross-sectional view of the long resin film indicated by reference sign (C) in FIG. 3, FIG. 4D is a cross-sectional view of the long resin film indicated by reference sign (D) in FIG. 3, and FIG. 4E is a cross-sectional view of the long resin film indicated by reference sign (E) in FIG. 3, wound up around a winding roll.

### DESCRIPTION OF THE PREFERRED EMBODIMENT

A vacuum deposition apparatus according to an embodiment of the present invention is described below in detail along with a vacuum deposition apparatus according to a conventional example and its problem.

### 1. Vacuum Deposition Apparatus According to Conventional Example

### (1) Configuration of Vacuum Deposition Apparatus According to Conventional Example

First, the vacuum deposition apparatus according to the conventional example is described in detail with reference to FIG. 1.

Note that in FIG. 1, motor driven rolls are denoted by reference sign M (motor), tension measurement rolls are denoted by reference sign TP (tension pick up), and free rolls are denoted by reference sign F (free).

As illustrated in FIG. 1, the vacuum deposition apparatus according to the conventional example includes an unwinding chamber 10, a drying chamber 20, a deposition chamber 30, and a winding chamber 40. Meanwhile, a "surface treatment chamber" in which plasma irradiation or ion beam irradiation is performed to improve the bond between a film and a metal film is provided in some cases between the drying chamber 20 and the deposition chamber 30.

In the unwinding chamber 10, an unwinding roll 11 is disposed around which is wound a long resin film 1 with no film deposited thereon or with a metal film (metal seed) deposited on one surface, and the unwinding chamber 10 is configured such that the long resin film 1 unwound from the unwinding roll 11 is transferred to the drying chamber 20 through a free roll 12, a tension measurement roll 13, and a free roll 14. Note that the unwinding chamber 10 is configured such that the tension of the film for the unwinding is measured by the tension measurement roll 13 and fed back to and controlled by the unwinding roll 11.

In the drying chamber 20, film drying heaters 22 are disposed, and the drying chamber 20 is configured such that the long resin film 1 transferred from the unwinding chamber 10 is transferred to the deposition chamber 30 through a motor driven roll 21, a free roll 23, a tension measurement roll 24, a free roll 25, and a free roll 26 while undergoing a drying process. Note that the drying chamber 20 is configured such that the tension of the film for the drying is measured by the tension measurement roll 24 and fed back to and controlled by the motor driven roll 21.

In the deposition chamber 30, sputtering cathodes 32, 33, 34, and 35 are disposed, and the deposition chamber 30 is configured such that the long resin film 1 transferred from the drying chamber 20 is transferred to the winding chamber 40 through a motor driven roll 36, a tension measurement roll 38, a can roll 31, a tension measurement roll 39, and a motor driven roll 37 while a metal film (metal seed) m is deposited on one surface (first surface 1α: see FIG. 2A) of the long resin film 1 (see FIG. 2B). Also, the tension of the film upstream of the can roll 31 (infeed tension) is measured by the tension measurement roll 38 and fed back to and controlled by the motor driven roll 36, and the tension of the film downstream of the can roll (outfeed tension) is measured by the tension measurement roll 39 and fed back to and controlled by the motor driven roll 37. Note that reference sign 3p in FIG. 1 denotes a shield plate configured to prevent sputtering particles ejected from the target of each sputtering cathode from traveling to, for example, the drying chamber 20 or the winding chamber 40 as a result of deviating from a predetermined travel path. Also, the tension of the film in the deposition chamber 30 (infeed tension and outfeed tension) is set to be about two to four times higher than the tension of the film for the unwinding in the unwinding chamber 10, the tension of the film for the drying in the drying chamber 20, and the tension of the film for the winding in the winding chamber 40.

In the winding chamber 40, a winding roll 41 and a long insertion sheet unwinding roll 42 are disposed, and the winding chamber 40 is configured such that the long resin film 1 with the metal film (metal seed) transferred from the deposition chamber 30 is wound up around the winding roll 41 through a free roll 44, a tension measurement roll 45, and a free roll 46 while a long insertion sheet 43 unwound from the long insertion sheet unwinding roll 42 is inserted between layers of the film through a free roll 47. Note that the winding chamber 40 is configured such that the tension of the film for the winding is measured by the tension measurement roll 45 and fed back to and controlled by the winding roll 41. Thus, the long resin film 1 having passed through the unwinding chamber 10, the drying chamber 20, and the deposition chamber 30 and thus having the metal film deposited thereon is wound up around the winding roll 41 in the winding chamber 40 while the long insertion sheet 43 is inserted between layers of the film.

Meanwhile, to deposit a metal film on both surfaces of the long resin film 1 by using the vacuum deposition apparatus, as mentioned above, the long resin film 1 after being wound up around the winding roll 41 with a metal film m deposited on the first surface 1α is taken out and then set on the unwinding roll 11 of the vacuum deposition apparatus again, and the long resin film 1 with the metal film m deposited on the first surface 1α is transferred from the unwinding chamber 10 into the deposition chamber 30. In this way, a metal film m can be deposited also on the second surface 1β of the long resin film 1. In this case, the film passage route from the unwinding roll 11 is the broken line illustrated in the unwinding chamber 10. Here, if the long resin film 1 with a metal film deposited on the second surface 1β is directly wound up around the winding roll 41, a blocking phenomenon occurs in which the metal films deposited on the first surface 1α side and the second surface 1β side strongly contact each other in vacuo and get attached to each other occurs. Thus, as in the case of depositing a metal film on one surface (first surface 1α) side, the long resin film 1 may be wound up around the winding roll 41 in the winding chamber 40 while the long insertion sheet 43 unwound from the long insertion sheet unwinding roll 42 is inserted between layers of the film. Note that FIG. 1 illustrates only the minimum required rolls for describing the vacuum deposition apparatus, and there are rolls that are not illustrated.

Further, the vacuum chambers constructed as the unwinding chamber 10, the drying chamber 20, the deposition chamber 30, and the winding chamber 40 each include evacuation equipment. In particular, in the deposition chamber 30, for the sputtering deposition, the pressure is lowered to about an ultimate pressure of 10⁻⁴ Pa and thereafter the pressure is adjusted to about 0.1 to 10 Pa via introduction of a sputtering gas. A publicly known gas such as argon is used as the sputtering gas and, depending on the purpose, a gas such as oxygen is further added. The shape and material of each vacuum chamber are not particularly limited but various shapes and materials are usable as long as they can withstand the above depressurized state. The vacuum chamber is equipped with various apparatuses not illustrated such as dry pumps, turbomolecular pumps, and cryocoils to depressurize the inside of the vacuum chamber and maintain that state.

Meanwhile, for sputtering deposition of a metal film (metal seed), plate-shaped targets are used, as illustrated in FIG. 1. However, in the case of using plate-shaped targets, generation of nodules (growth of foreign matter) may occur on the targets in some cases. If this is problematic, it is preferable to use cylindrical rotary targets, which are free from the generation of nodules and also have high target use efficiency. Also, magnetron sputtering cathodes are illustrated in the vacuum deposition apparatus in FIG. 1. However, in a case of using a different vacuum deposition apparatus for chemical vapor deposition (CVD), a vapor deposition process, or the like, different vacuum deposition means is incorporated in place of the plate-shaped targets.

### (2) Problem with Vacuum Deposition Apparatus According to Conventional Example

In the vacuum deposition apparatus according to the conventional example illustrated in FIG. 1, the tension of the long resin film 1 for the transfer in the deposition chamber 30 is set to be about two to four times higher than the tension of the film for the unwinding in the unwinding chamber 10, the tension of the film for the drying in the drying chamber 20, and the tension of the film for the winding in the winding chamber 40 since the long resin film 1 is brought into tight contact with the outer peripheral surface of the cooling can roll 31. Accordingly, the long resin film 1 transferred through the deposition chamber 30 strongly contacts the outer peripheral surfaces of the cooling can roll 31 and the motor driven rolls 36 and 37, which are provided inside the deposition chamber 30. Then, when the side of the long resin film 1 to be in contact with these outer peripheral surfaces is a film surface with no film deposited thereon, the film surface with no film deposited thereon is prone to be scratched. When the side of the long resin film 1 to be in contact with the outer peripheral surfaces is a deposited metal film, the metal film is prone to be scratched.

Thus, there has been a problem in that if the film surface with no film deposited thereon is scratched, asperities will be formed on the surface of a metal film subsequently deposited on the film surface, and if the metal film is scratched, missing portions are formed in the metal film and defects such as pinholes are prone to be formed in the metal film-coated resin film.

### 2. Vacuum Deposition Apparatus According to Embodiment of the Present Invention

### (1) Configuration of Vacuum Deposition Apparatus According to Embodiment of the Present Invention

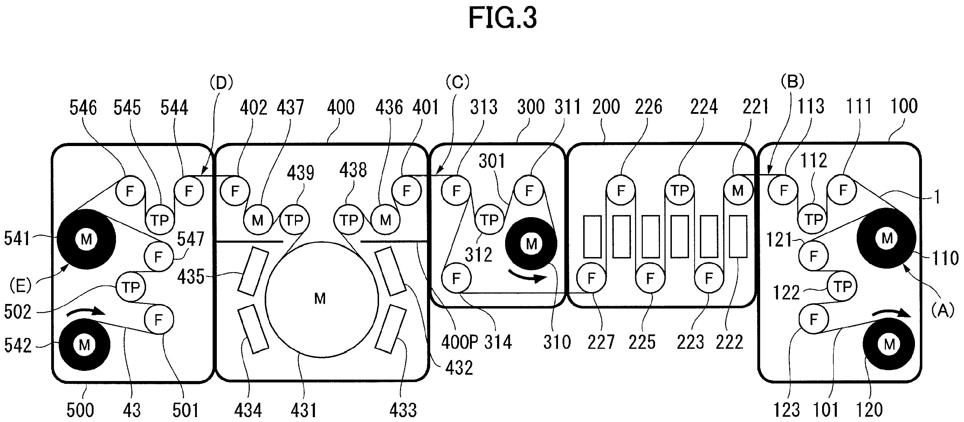

Next, the vacuum deposition apparatus according to the embodiment of the present invention is specifically described with reference to FIG. 3. In FIG. 3 too, motor driven rolls are denoted by reference sign M (motor), tension measurement rolls are denoted by reference sign TP (tension pick up), and free rolls are denoted by reference sign F (free).

As illustrated in FIG. 3, the vacuum deposition apparatus according to this embodiment includes an unwinding chamber 100, a drying chamber 200, a protection film laying chamber 300, a deposition chamber 400, and a winding chamber 500. Meanwhile, a "surface treatment chamber" in which plasma irradiation or ion beam irradiation is performed to improve the bond between a film and a metal film is provided in some cases between the drying chamber 200 and the protection film laying chamber 300.

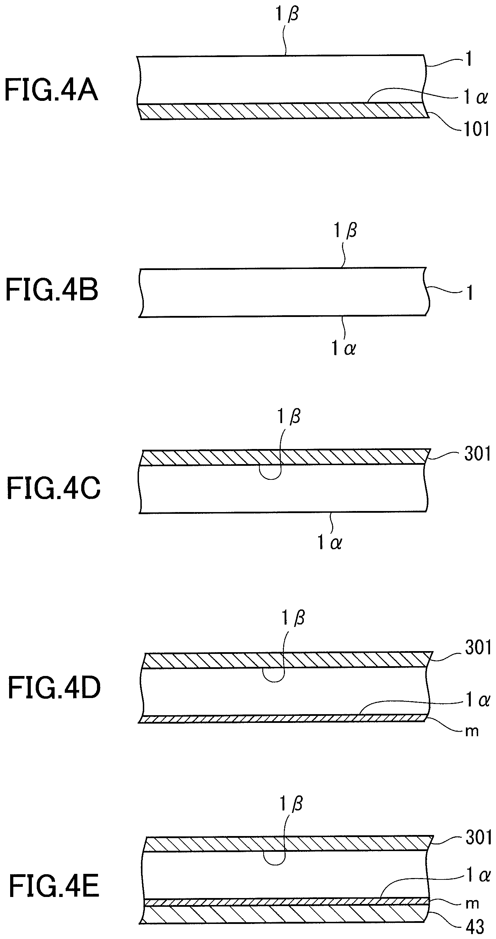

In the unwinding chamber 100 are disposed a unwinding roll 110 around which is wound a long resin film 1 with no film deposited thereon or with a metal film (metal seed) deposited on one surface, and a long insertion sheet winding roll 120 which separates and collects a long insertion sheet 101 inserted between layers of the long resin film 1 when the long resin film 1 is unwound from the unwinding roll 110. The unwinding chamber 100 is configured such that the long resin film 1 unwound from the unwinding roll 110 is transferred to the drying chamber 200 through a free roll 111, a tension measurement roll 112, and a free roll 113, and the long insertion sheet 101 separated from the long resin film 1 is collected by the long insertion sheet winding roll 120 through a free roll 121, a tension measurement roll 122, and a free roll 123. The unwinding chamber 100 is also configured such that the tension of the film for the unwinding from the unwinding roll 110 (e.g., 100 newtons (N)) is measured by the tension measurement roll 112 and fed back to and controlled by the unwinding roll 110, and the tension of the long insertion sheet for its winding is measured by the tension measurement roll 122 and fed back to and controlled by the long insertion sheet winding roll 120. Here, the long insertion sheet 101 may be inserted between layers of a long resin film without a film deposited on neither surface (see FIG. 4A) in order to prevent blocking between its film surfaces, and inserted between layers of a long resin film with a metal film (metal seed) deposited on one surface in order to prevent blocking of the metal film.

In the drying chamber 200, film drying heaters 222 are disposed, and the drying chamber 200 is configured such that the long resin film 1 (see FIG. 4B) transferred from the unwinding chamber 100 is transferred to the protection film laying chamber 300 through a motor driven roll 221, a free roll 223, a tension measurement roll 224, a free roll 225, a free roll 226, and a free roll 227 while undergoing a drying process. The drying chamber 20 is also configured such that the tension of the film for the drying (e.g., 50 newtons (N)) is measured by the tension measurement roll 224 and fed back to and controlled by the motor driven roll 221.

Also, in the protection film laying chamber 300, a protection film unwinding roll 310 that unwinds a protection film 301 is disposed, and the protection film laying chamber 300 is configured such that the protection film 301 unwound from the protection film unwinding roll 310 is transferred onto a free roll 313 through a free roll 311 and a tension measurement roll 312 while the long resin film 1 is transferred onto the free roll 313 from the drying chamber 200 through a free roll 227 therein and a free roll 314 in the protection film laying chamber 300, so that the protection film 301 is laid on the second surface 1β side of the long resin film 1 on the free roll 313 (see FIG. 4C). The protection film laying chamber 300 is also configured such that the tension of the protection film for the unwinding from the protection film unwinding roll 310 is measured by the tension measurement roll 312 and fed back to and controlled by the protection film unwinding roll 310.

Next, in the deposition chamber 400, sputtering cathodes 432, 433, 434, and 435 are disposed, and the deposition chamber 400 is configured such that the long resin film 1 transferred from the protection film laying chamber 300 and having the protection film 301 laid on the second surface 1β side is transferred to the winding chamber 500 through a free roll 401, a motor driven roll 436, a tension measurement roll 438, a can roll 431, a tension measurement roll 439, a motor driven roll 437, and a free roll 402 while a metal film (metal seed) m is deposited on one surface (first surface 1α: see FIG. 4C) of the long resin film 1 (see FIG. 4D). Also, the tension of the film upstream of the can roll 431 (infeed tension: e.g., 200 newtons (N)) is measured by the tension measurement roll 438 and fed back to and controlled by the motor driven roll 436, and the tension of the film downstream of the can roll (outfeed tension: e.g., 200 newtons (N)) is measured by the tension measurement roll 439 and fed back to and controlled by the motor driven roll 437. Note that reference sign 400p in FIG. 3 denotes a shield plate configured to prevent sputtering particles ejected from the target of each sputtering cathode from traveling to, for example, the protection film laying chamber 300 or the winding chamber 500 as a result of deviating from a predetermined travel path.

In the winding chamber 500, a winding roll 541 and a long insertion sheet unwinding roll 542 are disposed, and the winding chamber 500 is configured such that the long resin film 1 with the metal film (metal seed) transferred from the deposition chamber 400 is wound up around the winding roll 541 through a free roll 544, a tension measurement roll 545, and a free roll 546 while a long insertion sheet 43 unwound from the long insertion sheet unwinding roll 542 is inserted between layers of the film through a free roll 501, a tension measurement roll 502, and a free roll 547 (see FIG. 4E). The winding chamber 500 is also configured such that the tension of the long resin film for the winding (e.g., 100 newtons (N)) is measured by the tension measurement roll 545 and fed back to and controlled by the winding roll 541, and the tension of the long insertion sheet for the unwinding from the long insertion sheet unwinding roll 542 is measured by the tension measurement roll 502 and fed back to and controlled by the long insertion sheet unwinding roll 542.

Thus, the long resin film 1 having passed through the unwinding chamber 100, the drying chamber 200, the protection film laying chamber 300, and the deposition chamber 400 and thus having the metal film deposited thereon is wound up around the winding roll 541 in the winding chamber 500 while the long insertion sheet 43 is inserted between layers of the film.

Meanwhile, to deposit a metal film on both surfaces of the long resin film 1 by using the vacuum deposition apparatus according to this embodiment, as in the case of using the vacuum deposition apparatus according to the conventional example, the long resin film 1 after being wound up around the winding roll 541 with a metal film m deposited on the first surface 1α and a protection film laid on the second surface 1β is taken out and then set on the unwinding roll 110 of the vacuum deposition apparatus again. Thereafter, from the long resin film 1 with the metal film m deposited on the first surface 1α, the protection film is separated to thereby expose the second surface 1β, and the long resin film 1 is transferred in this state from the unwinding chamber 100 into the deposition chamber 400. In this way, a metal film m can be deposited also on the second surface 1β of the long resin film 1. Note that it is preferable to wind up the long resin film 1 around the winding roll 541 while inserting the long insertion sheet 43 unwound from the long insertion sheet unwinding roll 542 between layers of the film, in order to prevent the blocking phenomenon, as in the case of using the vacuum deposition apparatus according to the conventional example.

Further, the vacuum chambers constructed as the unwinding chamber 100, the drying chamber 200, the protection film laying chamber 300, the deposition chamber 400, and the winding chamber 500 each include evacuation equipment. In particular, in the deposition chamber 400, for the sputtering deposition, the pressure is lowered to about an ultimate pressure of 10⁻⁴ Pa and thereafter the pressure is adjusted to about 0.1 to 10 Pa via introduction of a sputtering gas. A publicly known gas such as argon is used as the sputtering gas and, depending on the purpose, a gas such as oxygen is further added. The shape and material of each vacuum chamber are not particularly limited but various shapes and materials are usable as long as they can withstand the above depressurized state. The vacuum chamber is equipped with various apparatuses not illustrated such as dry pumps, turbomolecular pumps, and cryocoils to depressurize the inside of the vacuum chamber and maintain that state.

Meanwhile, for sputtering deposition of a metal film (metal seed), plate-shaped targets are used, as illustrated in FIG. 3. However, in the case of using plate-shaped targets, generation of nodules (growth of foreign matter) may occur on the targets in some cases. If this is problematic, it is preferable to use cylindrical rotary targets, which are free from the generation of nodules and also have high target use efficiency. Also, magnetron sputtering cathodes are illustrated in the vacuum deposition apparatus in FIG. 3. However, in a case of using a different vacuum deposition apparatus for chemical vapor deposition (CVD), a vapor deposition process, or the like, different vacuum deposition means is incorporated in place of the plate-shaped targets.

### (2) Advantageous Effects of Vacuum Deposition Apparatus According to Embodiment of the Present Invention

In the vacuum deposition apparatus according to this embodiment, the protection film 301 is laid on the second surface 1β (see FIG. 4C) side of the long resin film 1 before the long resin film 1 is transferred into the deposition chamber 400. Thus, in the deposition chamber 400, the long resin film 1 is wrapped on the outer peripheral surface of the cooling can roll 431 with the protection film 301 interposed therebetween.

Then, although the long resin film 1 strongly contacts the outer peripheral surface of the cooling can roll 431 and the outer peripheral surfaces of the motor driven roll 436 and the motor driven roll 437 in the deposition chamber 400, the protection film 301 interposed between the long resin film 1 and these rolls makes the second surface 1β of the long resin film 1 less prone to be scratched. Hence, when the second surface 1β side of the long resin film 1 is a film surface with no film deposited thereon, the film surface with no film deposited thereon is less prone to be scratched. When the second surface 1β side is a metal film, the metal film surface is less prone to be scratched. This brings about a prominent advantage that a high-quality metal film-coated resin film without pinholes or the like in a wet plating layer formed on the metal film (metal seed) can be manufactured.

### (3) Film Materials

### (3-1) Long Resin Film

Examples of the long resin film employed in a metal film-coated resin film include a heat-resistant resin film selected from among a polyimide-based film, a polyamide-based film, a polyester-based film, a polytetrafluoroethylene-based film, a polyphenylene sulfide-based film, a polyethylene naphthalate-based film, and a liquid crystal polymer-based film, and the like. Metal film-coated resin films obtained by using these resin films are superior in flexibility required for the above-mentioned flexible wiring substrates, strength necessary for practical use, and electrical insulation performance suitable for wiring materials.

### (3-2) Protection Film

The protection film is made, for example, of polyethylene, polypropylene, polyethylene terephthalate, polyethylene naphthalate, polystyrene, polyvinyl alcohol, polycarbonate, polyphenylene sulfide, polyether ether ketone, polyethersulfone, aramid, polyimide, or triacetate alone or of a composite material thereof laminated to each other.

### (3-3) Long Insertion Sheet

Examples of the long insertion sheet to be inserted between layers of the long resin film include a heat-resistant resin film selected from among a polyimide-based film, a polyamide-based film, a polyester-based film, a polytetrafluoroethylene-based film, a polyphenylene sulfide-based film, a polyethylene naphthalate-based film, and a liquid crystal polymer-based film, and the like.

An example of the present invention is specifically described below.

### [Deposition of Metal Film (Metal Seed)]

By using the vacuum deposition apparatus (sputtering web coater) illustrated in FIG. 3, a metal film was deposited on the first surface 1α of a long resin film, and the long resin film with the metal film deposited on the first surface 1α side was set on the unwinding roll of the vacuum deposition apparatus again to deposit a metal film (metal seed) on both surfaces (first surface 1α and second surface 1β) of the long resin film. Note that as the long resin film 1 illustrated in FIG. 3, a heat-resistant polyimide film "UPILEX (registered trademark)", manufactured by Ube Industries, Ltd, measuring 600 mm in width, 1000 m in length, and 25 µm in thickness was used. The metal films (metal seeds) deposited on the first surface 1α and the second surface 1β of the long resin film 1 were each obtained by depositing a Ni-Cr film as a first layer and a Cu film as a second layer thereon.

Specifically, a Ni-Cr target was used as the target of the magnetron sputtering cathode 432 in the deposition chamber 400, and Cu targets were used as the targets of the magnetron sputtering cathodes 433, 434, and 435 in the deposition chamber 400. Then, in this state, the air in the deposition chamber 400 was evacuated to 5 Pa by using a plurality of dry pumps and evacuated further to 3 × 10⁻³ Pa by using a plurality of turbomolecular pumps and cryocoils.

Subsequently, the sputtering web coater's rotational drive apparatus was actuated to transfer the long resin film 1 at a transfer speed of 5 m/min while an argon gas was introduced at 300 sccm, and also an electric power of 20 kW was applied to the magnetron sputtering cathode with the Ni-Cr target and an electric power of 30 kW was applied to the magnetron sputtering cathodes with the Cu targets. As a result, a 25-nm-thick Ni-Cr film and a 100-nm-thick Cu film were deposited as a first layer and a second layer, respectively.

Then, the long resin film 1 with the above metal film (metal seed) deposited on the first surface 1α and the second surface 1β was transferred into the winding chamber 500, and the long resin film 1 was wound up around the winding roll 541 while the long insertion sheet 43 was inserted between layers of the long resin film 1 in order to avoid the occurrence of the blocking.

Note that 10-µm-thick PET films were employed as the long insertion sheet 43 and the protection film 301 to be laid on the second surface 1β side of the long resin film 1 in a state of being transferred. The tension of the film for the unwinding in the unwinding chamber 100 of the vacuum deposition apparatus (sputtering web coater) was set at 100 newtons (N). The tension of the film for the drying in the drying chamber 200 was set at 50 newtons (N). The tension of the film upstream of the can roll 431 in the deposition chamber 400 (infeed tension) and the tension of the film downstream of the can roll (outfeed tension) were each set at 200 newtons (N). The tension of the film for the winding in the winding chamber 500 was set at 100 newtons (N).

### [Formation of Wet Plating Layer]

The long resin film 1 with the metal film (metal seed), including the Ni-Cr layer and the Cu layer, deposited on both surfaces and the long insertion sheet 43 inserted between layers of the film for preventing the blocking was unwound from an unwinding roll in a "wet plating apparatus" while the long insertion sheet 43 was separated. Before the long resin film 1 was transferred into a plating bath, the surface of each metal film (metal seed) was cleaned by an "atmospheric-pressure plasma cleaning apparatus". Thereafter, the long resin film 1 was transferred into the plating bath of the "wet plating apparatus" at a transfer speed of 3 m/min to thereby plate the metal film (metal seed) with a 1-µm-thick Cu layer (wet plating layer).

### [Evaluation Method]

The presence of pinholes in the obtained metal film-coated resin film was evaluated. The evaluation was made by: firstly masking the metal layers (metal seed and wet plating layer) on one surface and removing the metal layers on the opposite surface by etching; capturing an image of pinholes within a 5.6 mm × 4.2 mm-field of view with a transmission microscope; and counting pinholes measuring 3 µm or larger in diameter by an image analysis.

It was observed from the result that the metal film-coated resin film obtained in this example had a significantly smaller number of pinholes than that in the case where the vacuum deposition apparatus according to the conventional example was used.

### POSSIBILITY OF INDUSTRIAL APPLICATION

According to the present invention, a high-quality metal film-coated resin film without pinholes or the like can be manufactured at a high yield. The present invention therefore is therefore industrially applicable as a manufacturing apparatus for metal film-coated resin films for use as flexible wiring substrates in laptop computers, digital cameras, mobile phones, and so on.

A vacuum deposition apparatus includes: an unwinding chamber for unwinding a long resin film wound around an unwinding roll; a deposition chamber for depositing a metal film on a first surface side of the resin film from the unwinding chamber; a winding chamber for winding up the resin film with the metal film around a winding roll. The deposition chamber includes a rotationally driven cooling can roll that cools the resin film transferred in a roll-to-roll manner by having the resin film wrapped on the outer peripheral surface of the can roll, and thermal load applying deposition means disposed along the outer peripheral surface. The apparatus includes a protection film laying chamber provided between the unwinding and deposition chambers for laying a protection film on a second surface side of the resin film in a transferred state to interpose the protection film between the can roll and the resin film.

## Claims

1. A vacuum deposition apparatus which comprises:
an unwinding chamber in which a long resin film wound around an unwinding roll is unwound;
a deposition chamber in which a metal film is deposited on a first surface side of the long resin film supplied from the unwinding chamber; and
a winding chamber in which the long resin film with the metal film deposited thereon is wound up around a winding roll,
wherein the deposition chamber comprises
a rotationally driven cooling can roll that cools the long resin film transferred in a roll-to-roll manner by having the long resin film wrapped on an outer peripheral surface of the cooling can roll, and
thermal load applying deposition means disposed along the outer peripheral surface of the cooling can roll, and
the vacuum deposition apparatus comprises a protection film laying chamber which is provided between the unwinding chamber and the deposition chamber and in which a protection film is laid on a second surface side of the long resin film in a state of being transferred to thereby be interposed between the cooling can roll and the long resin film.

2. The vacuum deposition apparatus according to claim 1, wherein the protection film is made of polyethylene, polypropylene, polyethylene terephthalate, polyethylene naphthalate, polystyrene, polyvinyl alcohol, polycarbonate, polyphenylene sulfide, polyether ether ketone, polyethersulfone, aramid, polyimide, or triacetate alone or of a composite material thereof laminated to each other.

3. The vacuum deposition apparatus according to claim 1, wherein the thermal load applying deposition means comprises a magnetron sputtering cathode.

4. A vacuum deposition method which comprises:
a film unwinding step of unwinding a long resin film wound around an unwinding roll;
a deposition step of wrapping the unwound long resin film onto a cooling can roll and depositing a metal film on a first surface side of the long resin film with thermal load applying deposition means disposed along an outer peripheral surface of the cooling can roll;
a film winding step of winding up the long resin film with the metal film deposited thereon around a winding roll; and
between the film unwinding step and the deposition step, a step of laying a protection film on a second surface side of the long resin film to thereby interpose the protection film between the cool can roll and the long resin film.

5. The vacuum deposition method according to claim 4, wherein the protection film is made of polyethylene, polypropylene, polyethylene terephthalate, polyethylene naphthalate, polystyrene, polyvinyl alcohol, polycarbonate, polyphenylene sulfide, polyether ether ketone, polyethersulfone, aramid, polyimide, or triacetate alone or of a composite material thereof laminated to each other.

6. The vacuum deposition method according to claim 4, wherein the thermal load applying deposition means comprises a magnetron sputtering cathode.
